# EUROPEAN PATENT APPLICATION

(11) **EP 1 321 975 A2**
(43) Date of publication of application: **25.06.2003**
(21) Application number: 02024484.4
(22) Date of filing: 30.10.2002
(51) Int. Cl.: H01L 21/316, C23C 16/40, H01L 21/768

(54) **Method for plasma depositing an insulating film with low dielectric constant for a semiconductor device**

(30) Priority: 05.12.2001 JP 2001371625
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Shioya, Yoshimi, Tokyo 108-0075 (JP); Maeda, Kazuo, Minato-ku, Tokyo 108-0075 (JP); Ikakura, Hiroshi, Minato-ku, Tokyo 108-0073 (JP)
(74) Representative: Marx, Lothar, Dr.

(57) **Abstract**

The present invention provides a manufacturing method of a semiconductor device, in which a main insulating film whose relative dielectric constant is drastically reduced can be formed on a barrier insulating film that covers wirings mainly consist of copper film. The configuration of the method is that film forming gas containing either siloxane or methylsilane, oxygen-containing gas, and etching gas, is transformed into plasma to cause reaction so as to form an insulating film 35b having low dielectric constant on a substrate 21 subject to deposition.

## Description

### BACKGROUND OF THE INVENTION

### 1. Field of the Invention

The present invention relates to a manufacturing method of a semiconductor device, particularly to a manufacturing method of a semiconductor device in which an insulating film having low dielectric constant is formed on wirings that mainly consist of a copper film, or in which a main insulating film having low dielectric constant is formed via a barrier insulating film thereon.

### 2. Description of the Prior Art

In recent years, a higher data transfer speed has been required with higher integration of a semiconductor integrated circuit device. For this reason, an insulating film (hereinafter, referred to as a low dielectric constant insulating film) having low dielectric constant is used for a small RC delay.

To form such a low dielectric constant insulating film, there is known a plasma enhanced CVD method (PE-CVD method) using trimethylsilane (SiH(CH₃)₃) and N₂O. For example, it is described in Electrochem. Soc. Fall Meeting Abstracts, p.344 (1998), or the like, M.J.Loboda, J.A.Seifferly, R.F.Schneider, and C.M.Grove. Further, a plasma enhanced CVD method using tetramethylsilane (Si(CH₃)₄) and N₂O is described in SEMICON Korea Technical Symposium 2000, p.279 (2000), or the like, J.Shi, M.A-Plano, T.Mountsier, and S.Nag.

Alternatively, there is known an example using an SOG film deposited by a coating method.

Incidentally, in the insulating film deposited by a CVD method using tetramethylsilane, or other types of organic silane and methane, relative dielectric constant of about 2.3 to 2.8 is generally obtained. However, practical use of the insulating film deposited by the CVD method is delayed under present circumstances comparing to the SOG film whose planarization is easy.

It is desired that the main insulating film on the barrier insulating film be deposited by the CVD method in future since deposition by the CVD method has possibility that it can produce the insulating film of better film quality than the SOG film. For this purpose, there is a need to further reduce the relative dielectric constant thereof.

### SUMMARY OF THE INVENTION

The object of the present invention is to provide a manufacturing method of a semiconductor device in which a main insulating film whose relative dielectric constant is drastically reduced can be formed on a barrier insulating film which covers wirings mainly consisting of a copper film.

In the manufacturing method of the semiconductor device in which film forming gas is transformed into plasma to cause reaction to form the insulating film having low dielectric constant on a substrate, the film forming gas is characterized in that it contains etching gas for a silicon-containing film, that is, any one of NF₃, CF₄, C₂F₆ and C₃F₈, for example, in addition to either siloxane or methylsilane (SiHₙ(CH₃)₄₋ₙ : n=0,1,2,3) and oxygen-containing gas.

In this case, deposition and etching are simultaneously caused during deposition of the silicon-containing insulating film because of containing etching gas such as NF₃ for a silicon-containing insulating film in the film forming gas. Therefore the formed silicon-containing insulating film becomes uneven in the surface thereof, and thus contains more vacancies inside the silicon-containing insulating film comparing to the case of only the film forming gas. Accordingly, the relative dielectric constant of the silicon-containing insulating film, which has been deposited by such film forming gas, can be drastically reduced.

Further adding cyclohexane (C₆H₁₂) or methylcyclohexane (CH₃C₆H₁₁) in mixed gas composed of either siloxane or methylsilane, oxygen-containing gas and etching gas results in increasing porosity of the silicon-containing insulating film and further reducing the relative dielectric constant of the silicon-containing insulating film.

### BRIEF DESCRIPTION OF THE DRAWINGS

Fig. 1 is a side view showing a configuration of a plasma enhanced chemical vapor deposition apparatus used in the manufacturing method of the semiconductor device according to an embodiment of the present invention.
Figs. 2A to 2D are cross-sectional views showing the semiconductor device and its manufacturing method according to an embodiment of the present invention.

### DESCRIPTION OF THE PREFERRED EMBODIMENT

Embodiments of the present invention will be described as follows with reference to the drawings.

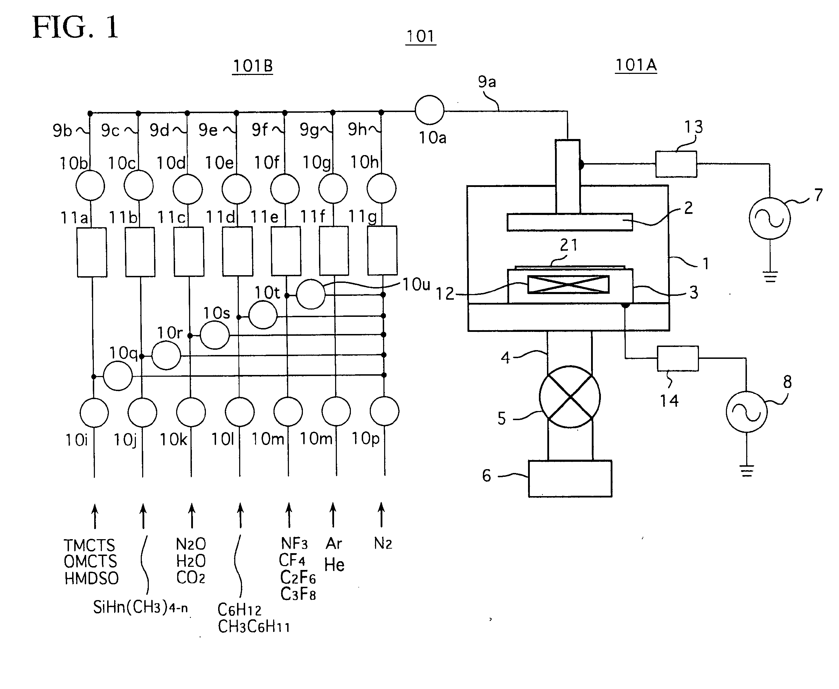

Fig. 1 is the side view showing the configuration of a parallel plate type plasma enhanced CVD apparatus 101 used in the manufacturing method of the semiconductor device according to the embodiment of the present invention.

The plasma enhanced CVD apparatus 101 is provided with: a deposition section 101A where the insulating film is formed on a substrate 21 subject to deposition (hereinafter, referred to simply as substrate) by plasma gas; and a film forming gas supply section 101B having a plurality of supply sources of gases that constitute the film forming gas.

The deposition section 101A includes a decompressive chamber 1 as shown in Fig. 1, and the chamber 1 is connected with an exhaust unit 6 via exhaust piping 4. An open/close valve 5 that controls communication/non-communication between the chamber 1 and the exhaust unit 6 is provided halfway the exhaust piping 4. The chamber 1 is provided with pressure measurement means such as a vacuum gauge (not shown) for monitoring the pressure inside the chamber 1.

There is provided a pair of an upper electrode 2 and a lower electrode 3, which are opposed to each other, in the chamber 1. A high frequency electric power supply source (RF power source) 7 that supplies high frequency electric power having the frequency of 13.56 MHz is connected to the upper electrode 2, and a low frequency electric power supply source 8 that supplies low frequency electric power having the frequency of 380 kHz is connected to the lower electrode 3. These power sources 7, 8 supply electric power to the upper electrode 2 and the lower electrode 3 respectively to transform the film forming gas into plasma. The upper electrode 2, the lower electrode 3 and the power sources 7, 8 constitute plasma generation means.

The upper electrode 2 also serves as a dispersion unit of the film forming gas. A plurality of through holes are formed on the upper electrode 2. Openings, which are provided on the opposing side of the through holes and face toward the lower electrode 3, serve as discharge ports (introduction ports) of the film forming gas or the like. The discharge ports are connected with the film forming gas supply section 101B by piping 9a. Further, there are cases where a heater (not shown) is provided for the upper electrode 2. This is because particles made of reaction product of the film forming gas are prevented from adhering to the upper electrode 2 by heating the upper electrode 2 to about 100°C during deposition.

The lower electrode 3 also serves as a substrate holder for the substrate 21, and it includes a heater 12 that heats the substrate 21 on the substrate holder.

The film forming gas supply section 101B is provided with: a supply source of siloxane; a supply source of methylsilane (SiHₙ(CH₃)₄₋ₙ :n=0,1,2,3); a supply source of oxygen-containing gas; a supply source of either cyclohexane (C₆H₁₂) or methylcyclohexane (CH₃C₆H₁₁); a supply source of etching gas; a supply source of dilute gas; and a supply source of nitrogen (N₂) that is dilute gas or purge gas.

These gases are appropriately supplied into the chamber 1 of the deposition section 101A through branch piping 9b to 9j and the piping 9a where all the branch piping 9b to 9g is connected. Flow rate adjustment means 11a to 11g and open/close means 10b to 10n, 10p that control open/close of the branch piping 9b to 9h are installed halfway the branch piping 9b to 9h. Open/close means 10a that controls open/close of the piping 9a is provided halfway the piping 9a.

Furthermore, open/close means 10q to 10u, which control communication/noncommunication between the supply source of N₂ gas and the branch piping 9h connected thereto and other branch piping 9b to 9f, are installed in order to purge residual gas in the branch piping 9b to 9f by flowing the N₂ gas. Note that the N₂ gas also purges residual gas in the piping 9a and the chamber 1 other than the branch piping 9b to 9f. The N₂ gas may be also used as the dilute gas.

As described above, the foregoing deposition apparatus 101 is provided with: the supply source of siloxane, the supply source of oxygen-containing gas; and the supply source of etching gas, and further provided with: the plasma generation means 2, 3, 7 and 8 that transform the film forming gas into plasma.

With this configuration, the insulating film having low dielectric constant can be formed by the plasma enhanced CVD method as shown in the embodiment below.

Then, there is provided, for example, means for generating plasma by the upper and lower electrodes 2, 3 of a parallel plate type as the plasma generation means. The power sources 7, 8 for supplying electric power of two (high and low) frequencies are respectively connected to the upper and lower electrodes 2, 3. Accordingly, the electric power of two (high and low) frequencies is applied to each electrode 2, 3, and thus plasma can be generated.

Following is a combination of applying the electric power to the upper electrode 2 and the lower electrode 3. Specifically, (i) the low frequency electric power having the frequency of 100 kHz or more and less than 1 MHz is applied to the lower electrode 3, (ii) the high frequency electric power of 1 MHz or more is applied to the upper electrode 2, or (iii) the low frequency electric power is applied to the lower electrode 3 and the high frequency electric power is applied to the upper electrode 2.

Next, gas shown below may be used as a typical example of siloxane, methylsilane, etching gas, oxygen-containing gas, and dilute gas, corresponding to the film forming gas which are applied for the present invention.
(i) Siloxane
   Hexamethyldisiloxane (HMDSO :(CH₃)₃Si-O-Si(CH₃)₃)
   Octamethylcyclotetrasiloxane
   (OMCTS :((CH₃)₂)₄Si₄O₄)

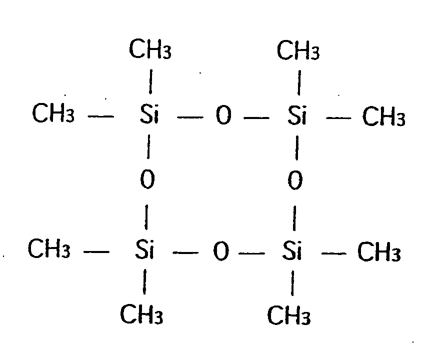

   Tetramethylcyclotetrasiloxane (TMCTS : (CH₃H)₄Si₄O₄) 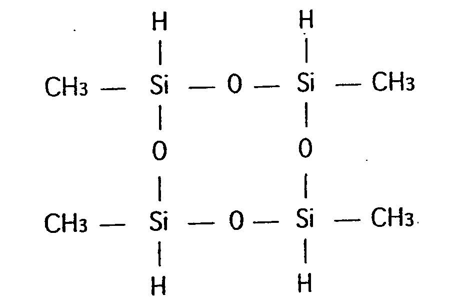
(ii) Methylsilane (SiHₙ(CH₃)₄₋ₙ :n=0,1,2,3)
   Monomethylsilane (SiH₃(CH₃))
   Dimethylsilane (SiH₂(CH₃)₂)
   Trimethylsilane (SiH(CH₃)₃)
   Tetramethylsilane (Si(CH₃)₄)
(iii) Etching gas
   NF3
   CF4
   C₂F₆
   C₃F₈
(iv) Oxygen-containing gas
   Nitrogen monoxide (N₂O)
   Water (H₂O)
   Carbon dioxide gas (CO₂)
(v) Dilute gas
   Helium (He)
   Argon (Ar)
   Nitrogen (N₂)

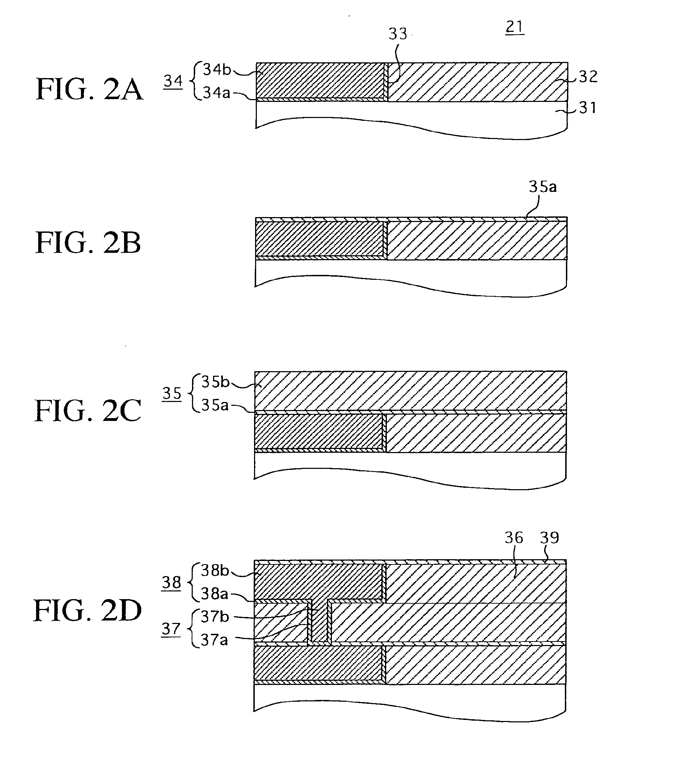

Next, description will be made for the manufacturing method of the semiconductor device, which is the embodiment of the present invention, referring to Figs. 2A to 2D. Figs. 2A to 2D are cross-sectional process views showing the manufacturing method of the semiconductor device according to the embodiments of the present invention.

The present invention is applied to a method of depositing an inter wiring layer insulating film 35 sandwiched between a lower wiring buried insulating film 32 in which a lower wiring 34 is buried and an upper wiring buried insulating film 36 in which an upper wiring 38 is buried. HMDS+N₂O+NF₃+He are used as the film forming gas, and the plasma enhanced CVD method is used as the deposition method.

The deposition conditions are shown as follows. Note that one minute and thirty seconds are reserved for time (stabilization period) necessary for substituting gas for use inside the chamber till starting of deposition (plasma excitation) from gas introduction. The upper electrode 2 is heated to 100°C to prevent reaction product from adhering to the upper electrode 2.
Deposition conditions
   Film forming gas
      HMDSO flow rate: 50 sccm
      N₂O flow rate: 200 sccm
      NF₃ flow rate: 200 sccm
      He flow rate: 400 sccm
      Gas pressure: 1.5 Torr
Plasma excitation conditions
   Lower electrode
      Low frequency electric power (frequency: 380 kHz): 0 W
   Upper electrode
      High frequency electric power (frequency: 13.56 MHz): 250 W
Substrate heating conditions: 375°C

Firstly, as shown in Fig. 2A, the lower wiring buried insulating film 32 formed of a PE-CVD SiO₂ film with the film thickness of about 1µm is formed on a substrate 31 by the plasma enhanced CVD method.

Subsequently, the lower wiring buried insulating film 32 is etched to form a wiring buried groove 33. Then, a TaN film 34a as a copper diffusion preventing film is formed on the inner surface of the wiring buried groove 33.

Then, a copper seed layer (not shown) is formed on the surface of the TaN film 34a by a sputtering method. Then, a copper film is buried thereon by a plating method. After that, the copper film and the TaN film protruded from the wiring buried groove 33 are polished by a CMP method (Chemical Mechanical Polishing method) to make the surface flat. Thus, the lower wiring 34 formed of the copper film 34b and the TaN film 34a is formed.

Then, a barrier insulating film 35a formed of the PE-CVD SiO₂ film is formed by the plasma enhanced CVD method. After that, a main insulating film 35b formed of the PE-CVD SiO₂ film is formed by the plasma enhanced CVD method using HMDSO+N₂O+NF₃+He. The films 35a, 35b described above constitute the inter wiring layer insulating film 35. It is described in detail as follows.

Specifically, in order to form the inter wiring layer insulating film 35, the substrate 31 is introduced into the chamber 1 of the deposition apparatus 101 first, and held by a substrate holder 3. Then, the substrate 31 is heated and its temperature is maintained at 375°C. HMDSO, N₂O gas and He gas are flown into the chamber 1 of the plasma enhanced deposition apparatus 101 shown in Fig. 1 at the flow rate of 50 sccm, 200 sccm and 400 sccm respectively, and the gas pressure inside the chamber 1 is adjusted to 1.5 Torr. Subsequently, the low frequency electric power of 150 W (corresponds to about 0.18 W/cm²) having the frequency of 380 kHz is applied to the lower electrode 3. Note that an appropriate electric power may be or may not be applied to the upper electrode 2.

The forming gas is thus transformed into plasma to cause reaction. This status is maintained for a predetermined time to form a barrier insulating film 35a formed of the PE-CVD SiO₂ film having the film thickness of about 100 nm. The ones described above constitute the substrate 21.

Subsequently, in the state where the temperature of the substrate 21 is maintained at 375°C, HMDSO, N₂O gas, NF₃ and He gas are introduced into the chamber 1 at the flow rate of 50 sccm, 200 sccm, 200 sccm and 400 sccm respectively, and the gas pressure is adjusted to 1.5 Torr. Then, the high frequency electric power of 250 W (corresponds to about 0.3 W/cm²) having the frequency of 13.56 MHz is applied to the upper electrode 2. Note that no electric power is applied to the lower electrode 3.

HMDSO, N₂O, NF₃ and He are thus transformed into plasma. This status is maintained for forty seconds to form the main insulating film 35b formed of the PE-CVD SiO₂ film having the film thickness of about 500 nm. In this case, since the film forming gas contains etching gas such as NF₃ for the silicon-containing insulating film, deposition and etching occur simultaneously. For this reason, the surface of the silicon-containing insulating film during deposition becomes uneven. Thus, the silicon-containing insulating film having more vacancies inside comparing to the case of only the film forming gas can be finally formed. Accordingly, the dielectric constant of the silicon-containing insulating film can be drastically reduced. Relative dielectric constant of 2.2 to 2.3 could be obtained in the silicon-containing insulating film through experiment.

As described above, the inter wiring layer insulating film 35 having the film thickness of about 600 nm, which is formed of the barrier insulating film 35a and the main insulating film 35b, is formed.

Next, the upper wiring buried insulating film 36 formed of the PE-CVD SiO₂ film having the film thickness of about 1µm is formed on the inter wiring layer insulating film 35 by the same method used in forming the PE-CVD SiO₂ film 32.

Then, a connection conductor 37 and the upper wiring 38, which are mainly formed of a copper film, are formed by a well-known dual-damascene method. Note that reference numerals 37a and 38a in the drawing denote the TaN film, and 37b and 38b denote the copper film.

Next, a barrier insulating film 39 is formed on the entire surface under the same conditions used in forming the barrier insulating film 35a. Thus, the semiconductor device is completed.

As described above, according to the embodiment of the present invention, gas containing NF₃ which is etching gas for the silicon-containing insulating film in addition to either siloxane or methylsilane (SiHₙ(CH₃)₄₋ ₙ :n=0,1,2,3) and oxygen-containing gas is used as the forming gas for the main insulating film 35b of the inter wiring layer insulating film 35, which has low dielectric constant.

Etching gas for the silicon-containing insulating film, which is mixed in the film forming gas, leads to formation of the silicon-containing insulating film having more vacancies inside. Thus, its dielectric constant can be drastically reduced.

As in the foregoing, although the present invention has been described in detail based on the embodiments, the scope of the present invention is not limited to the examples specifically shown in the embodiments. Changes of the foregoing embodiments within the scope of the spirit of the present invention are included in the scope of the present invention.

Other siloxane can be used instead of HMDSO used in the embodiments. Alternatively, methylsilane (SiHₙ(CH₃)₄₋ ₙ :n=0,1,2,3) can be used instead of siloxane. Description of the types of methylsilane is omitted, because it has already been described.

Further, the film forming gas may contain either methylcyclohexane (CH₃C₆H₁₁) or cyclohexane (C₆H₁₂) in addition to any one of siloxane and methylsilane, oxygen-containing gas, and etching gas. With this, porosity of the film increases and dielectric constant can be further reduced.

In addition, inert gas containing either argon (Ar) or nitrogen (N₂) instead of helium (He) may be added in the film forming gas. With this, so-called white turbidity can be prevented in the formed film. When occasion demands, the inert gas may be excluded from the film forming gas.

As described above, according to the present invention, in the manufacturing method of the semiconductor device, where the film forming gas is transformed into plasma to form the silicon-containing insulating film having low relative dielectric constant, gas containing etching gas for the silicon-containing insulating film in addition to either siloxane or methylsilane (SiHₙ(CH₃)₄₋ₙ :n=0,1,2,3) and oxygen-containing gas is used for the film formation.

Since deposition and etching are simultaneously caused during deposition of the silicon-containing insulating film because of containing etching gas such as NF₃ for the silicon-containing insulating film in the film forming gas, the formed silicon-containing insulating film becomes uneven in the surface thereof, and thus includes more vacancies inside comparing to the case of only the film forming gas without containing etching gas.

Accordingly, the relative dielectric constant of the silicon-containing insulating film, which has been deposited by the film forming gas containing etching gas for the silicon-containing insulating film, can be drastically reduced.

## Claims

1. A manufacturing method of a semiconductor device, in which film forming gas is transformed into plasma to cause reaction to form an insulating film (35b) having low dielectric constant on a substrate subject to deposition, being **characterized in that**:
said forming gas contains any one of siloxane and methylsilane, oxygen-containing gas, and etching gas.

2. The manufacturing method of the semiconductor device according to Claim 1, wherein
said film forming gas contains any one of cyclohexane and methylcyclohexane in addition to any one of siloxane and methylsilane, oxygen-containing gas, and etching gas.

3. The manufacturing method of the semiconductor device according to Claim 1, wherein
said siloxane in said film forming gas is any one of hexamethyldisiloxane (HMDSO:(CH₃)₃Si-O-Si(CH₃)₃), octamethylcyclotetrasiloxane (OMCTS:((CH₃)₂)₄Si₄O₄), and tetramethylcyclotetrasiloxane (TMCTS:(CH₃H)₄Si₄O₄).

4. The manufacturing method of the semiconductor device according to Claim 1, wherein
said oxygen-containing gas is any one of N₂O, H₂O, and CO₂.

5. The manufacturing method of the semiconductor device according to Claim 1, wherein
said etching gas is any one of NF₃, CF₄, C₂F₆, and C₃F₈.

6. The manufacturing method of the semiconductor device according to Claim 1, wherein
said film forming gas contains any one of helium (He), argon (Ar), and nitrogen (N₂).

7. The manufacturing method of the semiconductor device according to Claim 1, wherein
said substrate subject to deposition is provided on a surface thereof with a barrier insulating film (35a) which covers wirings (34) mainly consist of copper film.
